# EUROPEAN PATENT APPLICATION

(11) **EP 1 750 305 A2**
(43) Date of publication of application: **07.02.2007**
(21) Application number: 06076339.8
(22) Date of filing: 30.06.2006
(51) Int. Cl.: H01L 23/485

(54) **Integrated circuit with low-stress under-bump metallurgy**

(30) Priority: 05.08.2005 US 198419
(71) Applicant: Delphi Technologies, Inc., Troy, Michigan 48007 (US)
(72) Inventor: Stepniak, Frank, Noblesville, IN 46060 (US); Higdon, William D., Greentown, IN 46936 (US)
(74) Representative: Denton, Michael John

(57) **Abstract**

An integrated circuit (IC) (200) includes a semiconductor material (102), electronic circuitry (104) formed on the semiconductor material (102), a contact layer (106) formed on the electronic circuitry (104), a final passivation layer (108) formed on the contact layer (106) and an under-bump metallurgy (UBM) (216) formed on at least a portion of the final passivation layer (108). The contact layer (106) includes a plurality of contacts pads (106A) for providing external access to the electronic circuitry (104). The final passivation layer (108) includes a plurality of windows that extend through the final passivation layer (108) to the contact pads (106A). The UBM (216) includes an aluminum layer having a thickness of about 800 angstroms to about 1200 angstroms, a nickel/vanadium (Ni/V) layer having a thickness of about 800 angstroms to about 1200 angstroms and a copper (Cu) layer having a thickness of about 800 angstroms to about 1200 angstroms.

## Description

### Technical Field

The present invention is generally directed to an integrated circuit and, more specifically, to an integrated circuit with low-stress under-bump metallurgy that imparts reduced stress.

### Background of the Invention

For integrated circuits (ICs), such as flip-chips, proper selection of an application appropriate under-bump metallurgy (UBM) is essential, prior to application of a solder bump on a top surface of the flip-chip. In a typical traditional flip-chip, a UBM includes a plurality of metal layers, which are deposited onto a final passivation layer, which includes windows that allow access to input/output (I/O) pads of the flip-chip. In a typical flip-chip, the pads are made of a metal, such as aluminum, and the UBM consists of metal layers, e.g., aluminum (Al), nickel/vanadium (Ni/V) and copper (Cu), which are deposited in successive process steps. A relatively well known thin-film UBM has utilized 4000 angstroms of aluminum, 3500 angstroms of nickel/vanadium and 8000 angstroms of copper. Due to the desirability of eliminating lead from electronic products (to address environmental concerns), a number of manufacturers have proposed and/or developed UBMs for use with lead-free solder. Unfortunately, the high tin (Sn) content of lead-free solders has resulted in rapid consumption of copper from conventional UBMs, which has lead to solder ball delamination.

In an effort to address the solder ball delamination problem, some manufacturers have replaced the copper traditionally utilized in a UBM with nickel, due to the fact that nickel has a much slower reaction rate with tin. As noted above, the UBM provides a critical interface between an I/O pad of the IC and a solder bump, which is used for interconnecting the flip-chip to a substrate, e.g., a printed circuit board (PCB). In general, a UBM should provide: an application adequate adhesion to wafer passivation and I/O pads; protection of the I/O pads from the environment; a low-resistance contact between each of the I/O pads and their associated bump; an effective barrier to solder diffusion into the I/O pads; and a seed layer for solder wetability.

Today, the most common adhesion/barrier layer in a UBM stack includes either titanium (Ti) or a compound of titanium/tungsten (Ti/W). The Ti or Ti/W layers provide adhesion to the passivation layer and I/O pads of the IC and act as a diffusion barrier to solder. The most commonly used Ti/W composition is a composition including 10 percent by weight titanium and 90 percent by weight tungsten. As noted above, copper has been widely utilized as diffusion barrier/solderable layer that reacts with tin in the solder to form an intermetallic compound. Unfortunately, the reliability of the bond formed between the solder ball and the copper layer depends upon the thickness of the copper layer, the solder type and the electrical and thermal exposure the bond experiences, which also affects the copper consumption rate and subsequent intermetallic compound formation. To eliminate the requirement for thick copper, which can lead to solder reliability issues associated with stress, one company developed a UBM stack that included an aluminum (Al) layer, a nickel/vanadium (Ni/V) layer and a copper (Cu) layer, for use with eutectic solder.

In general, the increasing complexity of IC packing density has placed greater demand on the current carrying capability of flip-chip joints and has caused an explosion in on-chip routing. However, complex on-chip routing tends to overwhelm the advantages gained by scaling transistors, due to transmission delays in signals passing between active devices. These transmission delays are primarily due to a resistance-capacitance (RC) time constants of electrical interconnects. To improve the resistance of a circuit, a designer may substitute copper for the aluminum conductors and may lower the capacitance through the use of low-K dielectrics. Unfortunately, low-K dielectrics are notoriously fragile and do not have the necessary mechanical strength for many applications. For example, commercially available low-K dielectrics have not been suitable in high-current flip-chip applications where copper bumps, e.g., mini-bumps or pillar-bumps, are utilized, due to the fact that the copper bumps result in relatively high-stresses derived from the substantial thickness, typically 80,000 angstroms or greater, of the copper bumps. While copper mini-bumps can be formed in a non-equilibrium configuration that generates little stress in the IC substrate, a single heating cycle, such as the heating cycle that is required for solder reflow during assembly, may cause recrystallization of the copper grains and concurrent increases in film and IC substrate stress.

What is needed is an under-bump metallurgy that substantially preserves the structural integrity of an integrated circuit (IC) without compromising functionality of the IC at a given temperature and/or current density mission profile.

### Summary of the Invention

According to one embodiment of the present invention, an integrated circuit (IC) includes a semiconductor material, electronic circuitry formed on the semiconductor material, a contact layer formed on the electronic circuitry, a final passivation layer formed on the contact layer and an under-bump metallurgy (UBM) formed on at least a portion of the final passivation layer. The contact layer includes a plurality of contacts pads for providing access to the electronic circuitry. The final passivation layer includes a plurality of windows that extend through the final passivation layer to the contact pads. The UBM includes an aluminum layer having a thickness of about 800 angstroms to about 1200 angstroms, a nickel/vanadium (Ni/V) layer having a thickness of about 800 angstroms to about 1200 angstroms and a copper (Cu) layer having a thickness of about 800 angstroms to about 1200 angstroms. Portions of the UBM extend through the windows to provide electrical interconnection to the contact pads.

According to another aspect of the present invention, the final passivation layer may be a nitride, oxide or polymer (e.g., polyimide or benzocyclobutene) film. According to a different aspect of the present invention, the contact layer is made of aluminum or copper. According to yet another embodiment of the present invention, the integrated circuit (IC) includes a plurality of solder bumps, with a different one of the solder bumps electrically interconnected to each of the contact pads. According to this aspect of the present invention, the solder bumps may be made of a tin-based alloy doped with copper. In this embodiment, the copper of the solder bumps may be between about 1 percent and about 10 percent by weight. According to a different aspect of the present invention, the aluminum layer includes about 0 to 5 weight percent of copper or silicon and the Ni/V layer includes about 93 percent nickel and about 7 percent vanadium by weight.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
Fig. 1 is a cross-sectional view of a relevant portion of an integrated circuit (IC) that includes a two-layer under-bump metallurgy (UBM), constructed according to one embodiment of the present invention;
Fig. 2 is a cross-sectional view of a relevant portion of an IC that includes a three-layer UBM, constructed according to another embodiment of the present invention; and
Fig. 3 is a cross-sectional view of a relevant portion of an electronic assembly constructed according to another embodiment of the present invention.

### Description of the Preferred Embodiments

According to various embodiments of the present invention, an under-bump metallurgy (UBM) may be tailored to meet the requirements of low-stress under the constraints of a specified current carry capability and operating temperature. The UBMs described herein are particularly advantageous in applications where a solder bump is a tin-based solder alloy doped with copper. As noted above, a commonly used thin-film UBM is composed of 4000 angstroms of aluminum, 3500 angstroms of nickel/vanadium and 8000 angstroms of copper. As compared to the present state of prior art UBMs, a factor of three in reduction of film stress may be achieved for a UBM that includes 1000 angstroms of aluminum, 1000 angstroms of nickel/vanadium and 1000 angstroms of copper. According to another aspect of the present invention, a film stress factor reduction of about 15 can be achieved through the use of a UBM that includes 500 angstroms of aluminum and 1000 angstroms of copper.

As noted above, tin-based solder alloys that include small amounts of copper may be utilized to reduce the rate of intermetallic formation between the solder and the UBM and, thus, slow the attack of the solderable UBM layer. By reducing the solderable layer consumption rate, the UBM can be made considerably thinner, which, in turn, exerts less stress on fragile low-K dielectrics. Thus, an electronic assembly can be designed that implements a low-K dielectric with reduced stress. Furthermore, a no-flow underfill may be placed between a flip-chip and an associated substrate of an electronic assembly to further distribute mechanical loads across an entire die surface to eliminate stress concentration at the I/O pads. Alternatively, a layer of pre-encapsulate (with a custom matched coefficient of thermal expansion (CTE)) may be applied to the flip-chip, during or after bumping, in concert with a low-stress UBM. Assuming the pre-encapsulate layer adjoins the bumps, it distributes any bump sheer loads across the surface of the die.

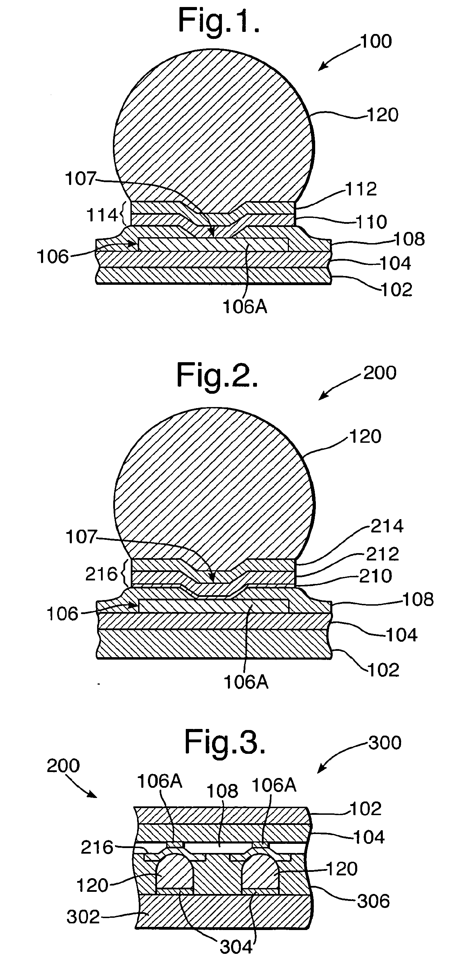

With reference to Fig. 1, a relevant portion of a bumped integrated circuit (IC) 100, e.g., a flip-chip, is illustrated. The flip-chip 100 includes electronic circuitry 104 formed on a semiconductor material 102, e.g., silicon. A plurality of contact pads 106A, formed in a contact layer 106, provide for external access to the electronic circuitry 104. Multiple layers of electronic circuitry are often necessary, individual layers separated by dielectric, to interconnect the active devices on the die. Historically, the dielectric consists of SiO₂ but may be modified to reduce the material's dielectric constant (so-called low-K dielectric). A final passivation layer 108, e.g., usually a nitride layer (e.g., Si₃N₄) or oxide layer (e.g., SiO₂), is formed on the contact layer 106, e.g., a metal layer. The final passivation layer 108 includes a plurality of windows 107, whose sidewalls may be sloped (e.g., ten degrees from vertical), that extend through the final passivation layer 108 to allow for electrical contact to the contact pads 106A. A two-layer under-bump metallurgy (UBM) 114 includes an aluminum layer 110 (having a thickness of about 500 angstroms +/- 100 angstroms) and a copper layer 112 (having a thickness of about 1000 angstroms +/- 200 angstroms). In this embodiment, the stress experienced by the silicon under the UBM is about 3.5x10⁶ dyne/cm² at 20 degrees C following solder reflow. As is shown, a solder bump 120 is electrically interconnected to an appropriate portion of the copper layer 112 of the UBM 114. As noted above, the configuration of the UBM 114 reduces the stress on the silicon by a factor of about 15, as compared to UBMs of the prior art noted above.

With reference to Fig. 2, a relevant portion of an integrated circuit (IC) 200, e.g., a flip-chip, is depicted in cross-section. Similar to the circuit of Fig. 1, electronic circuitry 104 is formed on a semiconductor material 102, e.g., silicon. Likewise, a contact layer 106 is formed on the semiconductor material 102 in desired locations over the electronic circuitry 104. As noted above, the contact layer 106 includes a plurality of contact pads 106A that provide external access to the electronic circuitry 104. A final passivation layer 108 is formed on the contact layer 106 and the final passivation layer 108 includes a plurality of windows 107 that extend through the final passivation layer 108 to the contact pads 106A. A three-layer under-bump metallurgy (UBM) 216, which includes an aluminum layer 210 (having a thickness of about 1000 angstroms +/- 200 angstroms), a nickel/vanadium layer 212 (having a thickness of about 1000 angstroms +/- 200 angstroms) and a copper layer 214 (having a thickness of about 1000 angstroms +/- 500 angstroms), is formed over the final passivation layer 108. In this embodiment, the stress experienced by the silicon under the UBM 216 is about 1.6x10⁷ dyne/cm² at 20 degrees C following solder reflow. Similar to the IC 100 of Fig. 1, the IC 200 of Fig. 2 includes a plurality of solder bumps 120, which may be, for example, a tin-based lead-free alloy including from about 1 to 10 percent copper, that interconnect I/O pads 106A to a substrate.

With reference to Fig. 3, an electronic assembly 300 is depicted that includes a substrate 302, which includes a plurality of electrically conductive traces 304 formed on a first surface of the substrate 302. As is shown, the assembly 300 also includes an integrated circuit (IC) 200, which is described above in conjunction with Fig. 2. The contact pads 106A of the IC 200 are electrically interconnected to the conductive traces 304 of the substrate 302 by solder balls 120, which are electrically and mechanical interconnected with the UBM 216. The assembly 300 also includes an underfill material 306, e.g., a no-flow underfill such as a functionalized epoxy incorporating fluxing agents, that distributes mechanical loads across an entire surface of the IC 200 to eliminate stress concentration at the contact pads 106A. Alternatively, the underfill 306 may be a pre-encapsulate with a custom matched coefficient of thermal expansion (CTE) that may be applied to the IC 200 during (or after) bumping, in concert with a low-stress UBM. Assuming the pre-encapsulate layer adjoins the bumps, it distributes any bump sheer loads across the surface of the IC 200.

In contrast to a traditional capillary underfill, where the underfill is applied and cured after the assembly is completed by solder reflow, the underfill described herein may be applied before reflow occurs. During the high-temperature stage of the reflow process, the no-flow underfill both fluxes to ensure adequate solder wetting between the die and the substrate and cures by cross-linking of individual epoxy groups. The curing action during reflow allows stress distribution, while the assembly cools following the reflow process, greatly reducing global thermal strains generated by the coefficient of thermal expansion (CTE) mismatch between the die and the substrate. Further mechanical relief of the flip-chip is possible if the solder is applied to the substrate, as opposed to the die. Again, the cured no-flow underfill provides support after the substrate supplied solder wets to the UBM-defined flip-chip.

Accordingly, a solder bumped integrated circuit (IC) has been described herein that advantageously exhibits reduced stress, while functioning reliably for a given temperature and current density requirement. For the underhood automotive environment, the stress on silicon of the IC that is imparted by the UBM can be reduced by a factor of two while operating at 150 degrees C and 2000 A/cm² for 1000hrs. As noted above, still lower stresses may be achieved for less severe applications. Table 1, set forth below, illustrates approximate and normalized substrate stress values following reflow for different UBM thicknesses. Performance in high temperature storage of the soldered structure is also shown in Table 1, as a function of UBM thickness employing a solder composition of 62Sn, 36Pb and 2Cu by weight percent.

| UBM Structure (in kÅ) | Accelerated Testing | Substrate (IC) Stress (normalized) |
|---|---|---|
| Cu/NiV/Al | | |
| 8 / 3.5 / 4 | 10,000hrs/150°C | 1.0 |
| 2 / 3.5 / 1 | 5000hrs/150°C | 0.66 |
| 2 / 2.0 / 1 | 1000hrs/150°C | 0.48 |
| 1 / 1.0 / 1 | 1000hrs/125°C | 0.30 |
| 1 / 0 / 0.5 | 1000hrs/85°C | 0.06 |

It is contemplated that a palladium or platinum layer may be substituted for the nickel/vanadium layer and/or a silver or gold layer may replace the copper layer when deposited in the thickness ranges, as described above. The stress and reliability performance can be comparable to the disclosed embodiments, but typically at a higher cost. Those skilled in the art will recognize several metal choices are available for the adhesion layer of the UBM stack, including Ti, Ti/W or Cr. In a typical application, the Ti/W layer is composed of about 10 percent titanium and about 90 percent tungsten by weight. Each can be used in place of an aluminum adhesion layer so long as the metal deposition conditions favor low-intrinsic film stresses and the metal film thicknesses described herein are substantially followed.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. An integrated circuit (IC) (200), comprising:
a semiconductor material (102);
electronic circuitry (104) formed on the semiconductor material (102);
a contact layer (106) formed on the electronic circuitry (104), wherein the contact layer (106) includes a plurality of contact pads (106A) for providing access to the electronic circuitry (104);
a final passivation layer (108) formed on the contact layer (106), wherein the final passivation layer (108) includes a plurality of windows that extend through the final passivation layer (108) to the contact pads (106A); and
an under-bump metallurgy (UBM) (216) formed on at least a portion of the final passivation layer (108), wherein the UBM (216) includes an aluminum layer having a thickness of about 800 angstroms to about 1200 angstroms, a nickel/vanadium (Ni/V) layer having a thickness of about 800 angstroms to about 1200 angstroms and a copper (Cu) layer having a thickness of about 800 angstroms to about 1200 angstroms, and wherein portions of the UBM (216) extend through the windows to provide electrical interconnection to the contact pads (106A).

2. The IC (200) of claim 1, wherein a structure underlying the UBM (216) is vulnerable to mechanical damage resulting from stress applied by the UBM (216).

3. The IC (200) of claim 2, wherein the underlying structure utilizes a low-K dielectric.

4. The IC (200) of claim 3, wherein the final passivation layer (108) is a nitride, oxide or polymer film.

5. The IC (200) of claim 1, wherein the contact layer (106) is made of aluminum or copper.

6. The IC (200) of claim 1, further comprising:
a plurality of solder bumps (120), wherein a different one of the solder bumps (120) is electrically interconnected to each of the contact pads (106A).

7. The IC (200) of claim 6, wherein the solder bumps (120) are made of a tin-based alloy doped with copper.

8. The IC (200) of claim 7, wherein the copper of the solder bumps (120) is between about 1 percent and about 10 percent by weight.

9. The IC (200) of claim 1, wherein the aluminum layer includes about 0 to 5 percent of copper or silicon, and wherein the Ni/V layer includes about ninety-three percent nickel and about seven percent vanadium by weight.

10. An integrated circuit (IC) (100), comprising:
a semiconductor material (102);
electronic circuitry (104) formed on the semiconductor material (102);
a contact layer (106) formed on the electronic circuitry (104), wherein the contact layer (106) includes a plurality of contact pads (106A) for providing access to the electronic circuitry (104);
a final passivation layer (108) formed on the contact layer (106), wherein the final passivation layer (108) includes a plurality of windows that extend through the final passivation layer (108) to the contact pads (106A); and
an under-bump metallurgy (UBM) (114) formed on at least a portion of the final passivation layer (108), wherein the UBM (114) includes an aluminum layer having a thickness of about 400 angstroms to about 600 angstroms and a copper (Cu) layer having a thickness of about 800 angstroms to about 1200 angstroms, and wherein portions of the UBM (114) extend through the windows to provide electrical interconnection to the contact pads (106A).

11. The IC (100) of claim of 10, wherein a structure underlying the UBM (114) is vulnerable to mechanical damage resulting from stress applied by the UBM (114).

12. The IC (100) of claim 11, wherein the underlying structure utilizes a low-K dielectric.

13. The IC (100) of claim 10, wherein the final passivation layer (108) is a nitride, oxide or polymer film.

14. The IC (100) of claim 10, wherein the contact layer (106) is made of aluminum or copper.

15. The IC (100) of claim 10, further comprising:
a plurality of solder bumps (120), wherein a different one of the solder bumps (120) is electrically interconnected to each of the contact pads (106A).

16. The IC (100) of claim 15, wherein the solder bumps (120) are made of a tin-based alloy doped with copper.

17. The IC (100) of claim 16, wherein the copper of the solder bumps (120) is between about 1 percent and about 10 percent by weight.

18. The IC (100) of claim 10, wherein the aluminum layer includes about 0 to 5 weight percent of copper or silicon.

19. An electronic assembly (300), comprising:
a substrate (302) including a plurality of electrically conductive traces (304) formed on a first surface of the substrate (302); and
an integrated circuit (IC) (200), comprising:
a semiconductor material (102);
electronic circuitry (104) formed on the semiconductor material (102);
a contact layer (106) formed on the electronic circuitry (104), wherein the contact layer (106) includes a plurality of contact pads (106A) for providing access to the electronic circuitry (104);
a final passivation layer (108) formed on the contact layer (106), wherein the final passivation layer (108) includes a plurality of windows that extend through the final passivation layer (108) to the contact pads (106A);
an under-bump metallurgy (UBM) (216) formed on at least a portion of the final passivation layer (108), wherein portions of the UBM (216) extend through the windows to provide electrical interconnection to the contact pads (106A); and
a plurality of solder bumps (120), wherein a different one of the solder bumps (120) is positioned to electrically interconnect each of the contact pads (106A) to a different one of the conductive traces (304), and wherein a stress applied by the UBM (216) to an underlying structure is less than about 3.5x10⁶ dyne/cm² at 20 degrees C.

20. The assembly (300) of claim 19, further comprising:
an underfill material (306) positioned between the IC (200) and the substrate (302) to provide mechanical support and stress relief.

21. The assembly (300) of claim 19, wherein the contact layer (106) is made of aluminum or copper.

22. The assembly (300) of claim 19, wherein the solder bumps (120) are made of a tin-based alloy doped with copper, and wherein the copper of the solder bumps (120) is between about 1 percent and about 10 percent by weight.
